# EUROPEAN PATENT APPLICATION

(11) **EP 1 608 014 A1**
(43) Date of publication of application: **21.12.2005**
(21) Application number: 04716770.5
(22) Date of filing: 03.03.2004
(51) Int. Cl.: H01L 23/40, H05K 7/20, H02M 7/48

(54) **HEAT RADIATOR**

(30) Priority: 25.03.2003 JP 2003082337
(71) Applicant: Toshiba Carrier Corporation, Tokyo 105-8001 (JP)
(72) Inventor: SHIMIZU, Shinya, 4160932 (JP); IKEYA, Satoshi, 4160945 (JP); HIRUMA, Atsuyuki, 4180023 (JP); MURASHIGE, Yoshinori, 4160908 (JP); ENDO, Takahisa, 4160908 (JP); HASEGAWA, Norihisa, 4213104 (JP)
(74) Representative: HOFFMANN EITLE
(86) International application number: PCT/JP2004/002618
(87) International publication number: WO 2004/086501

(57) **Abstract**

It is an object to provide a heat radiation system in which, even though there is variation in thickness among six switching devices, all of these devices can securely be adhered by means of a single fixing plate to a heat sink.

The fixing plate for fixing to a heat sink six switching devices U, X, V, Y, W, and Z arranged in a line on a printed board is made of a single metal plate to which forming processing has been applied, and has a base portion (11) formed being elongated in a direction in which the switching devices are arranged and three device-pressing portions (15) provided at one side of the base portion, in an elongated form being spaced apart form each other and being coupled through coupling portions (14) with the base portion, wherein the device-pressing portion has a width, in the longitudinal direction of the base portion, for pressing two of the switching devices as a pair, and has a through-hole (16) for a screw, formed in the middle of the longitudinal width thereof, for sandwiching the switching device between the device-pressing portion and the heat sink, and fastening the switching device to the heat sink; and wherein the coupling portion is formed so as to have a width smaller than that of the device-pressing portion so that the device-pressing portion can be moved obliquely against the heat sink.

## Description

### CROSS REFERENCE TO RELATED APPLICATIONS

This application is based upon and claims the benefit of priority from the prior Japanese Patent Application No. 2003-82337, filed on March 25, 2003, the entire contents of which are incorporated herein by reference.

### BACKGROUND OF THE INVENTION

### Field of the Invention

The present invention relates to a heat radiation system including a fixing plate for, in an apparatus that utilizes six switching devices, such as a three-phase inverter, fixing to a heat sink the six switching devices arranged in a line on a printed board.

### Related Art

For example, when capacity-control operation of the compressor of an air conditioner is implemented, an inverter is utilized in which AC voltage is full-wave rectified by a rectifier, the resultant DC voltage is inverted through the main circuit of the inverter into AC voltage, and then the resultant AC voltage is supplied to a motor for driving the compressor. The inverter main circuit is made up of six switching devices, such as transistors or IGBTs, that are in three-phase bridge connection.

Large current flows through each of these switching devices, thereby causing a large amount of heat to be generated; therefore, if no measures are taken, the switching device may undergo thermal destruction. Thus, measures are taken in which, by fixing a switching device to a heat sink made of a material having a large heat conductivity, such as aluminum, thereby raising radiating performance, the temperature of the switching device does not become the same as or higher than a predetermined temperature.

As an example of a conventional method of fixing a switching device to a heat sink, a heat radiation system has been disclosed (e.g., refer to Japanese Laid-Open Patent Application No. 2000-68671) in which four heat-generating devices arranged in a line are pressed by a single retaining plate through a buffer material against a heat sink, and the center portion of the retaining plate is fixed being tightened by means of a screw to the heat sink.

As another example of this kind of conventional method, a heat radiation system has been disclosed in which two semiconductor electronic components are pressed by means of a single elastic material against a heat sink (e.g., refer to Japanese Laid-Open Utility Model Application No. 1990-9445).

Because, in these heat radiation systems, a plurality of heat-generating devices is concurrently fixed to a heat sink, workability in fixing of these devices can be raised in comparison to a system in which these heat-generating devices are fixed by means of a screw or the like to a heat sink one by one.

### SUMMARY OF THE INVENTION

Out of the heat radiation systems described above, in the system in which four heat-generating devices are fixed being tightened by a single retaining plate, because a buffer material is sandwiched between the device and the retaining plate, all of these devices are adhered to the heat sink regardless of variation in thickness among the devices; however, there is an issue in that the buffer material should always be provided.

Moreover, in the system in which two devices are fixed by means of an elastic material to a heat sink, because two devices make one set, three elastic materials should be prepared, in order to fix six switching devices that configure the inverter main circuit.

Still moreover, in the two kinds of heat radiation systems described above, there is nothing to define the positions of the devices, in tightening and fixing the devices; therefore, insulation performance may be deteriorated due to spacing between adjacent devices being narrowed.

It is an object of the present invention to provide a heat radiation system in which, even though there is variation in thickness among six switching devices, all of these devices can securely be adhered by means of a single fixing plate to a heat sink.

It is another object of the present invention to provide a heat radiation system in which it is possible to keep neighboring devices appropriately spaced apart from each other.

In order to achieve the foregoing objects, the present invention provides a heat radiation system including a fixing plate for fixing to a heat sink six switching devices arranged in a line on a printed board, wherein the fixing plate is made of a single metal plate to which forming processing has been applied, and has a base portion formed being elongated in a direction in which the switching devices are arranged and three device-pressing portions provided at one side of the base portion, in an elongated form being spaced apart form each other and being coupled through coupling portions with the base portion; wherein the device-pressing portion has a width, in the longitudinal direction of the base portion, for pressing two of the switching devices as a pair, and has a through-hole for a screw, formed in the middle of the longitudinal width thereof, for sandwiching the switching device between the device-pressing portion and the heat sink, and fastening the switching device to the heat sink; and wherein the coupling portion is formed so as to have a width smaller than that of the device-pressing portion so that, when the switching device is sandwiched and the device-pressing portion is fastened to the heat sink, the device-pressing portion can be moved obliquely against the heat sink.

### BRIEF DESCRIPTION OF THE DRAWINGS

Fig. 1 is a circuit diagram schematically illustrating a configuration of a main circuit of an inverter to which the present invention is applied;
Fig. 2 is a perspective view illustrating First Embodiment of the present invention, accompanied by a rectifier being mounted;
Figs. 3(a) and 3(b) are perspective views illustrating in detail a configuration of a fixing plate incorporated in First Embodiment of the present invention;
Fig. 4 is a perspective view illustrating switching devices being mounted on a printed board, in a mounting procedure of First Embodiment;
Fig. 5 is a perspective view illustrating a configuration of a positioning jig for the switching devices illustrated in Fig. 4;
Fig. 6 is a side view illustrating the positioning jig, illustrated in Fig. 5, being applied;
Figs. 7 is a cross-sectional view illustrating a configuration of a heat sink incorporated in First Embodiment and a condition of the heat sink being mounted;
Fig. 8 is a cross-sectional view illustrating a condition in which, even though switching devices differ in thickness, respective contact surfaces of the switching devices are adhered to a heat sink in First Embodiment;
Fig. 9 is a perspective view illustrating in detail a configuration of a fixing plate incorporated in Second Embodiment of the present invention; and
Fig. 10 is a cross-sectional view illustrating a condition in which respective contact surfaces of switching devices are adhered to a heat sink and respective spaces between neighboring switching devices are defined in Second Embodiment.

### DETAILED DESCRIPTION OF THE INVENTION

The present invention will be explained in detail below, in accordance with preferred embodiments illustrated in the drawings.

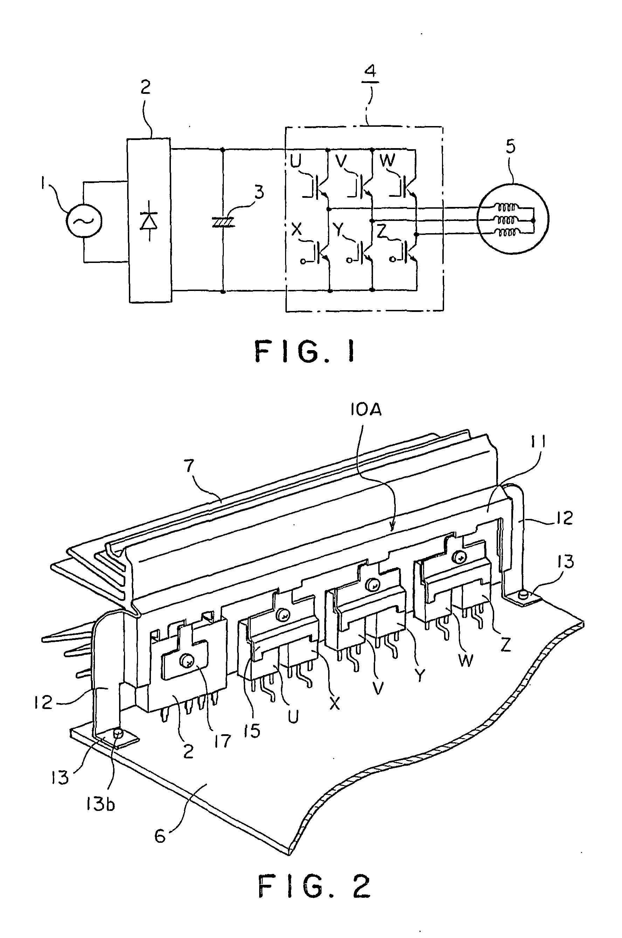

Fig. 1 is a circuit diagram schematically illustrating a configuration of a main circuit of an inverter to which the present invention is applied. In Fig. 1, a full-wave rectifier 2 is connected to a single-phase AC power supply 1; the rectifier 2 outputs a full-wave-rectified pulsating current. The pulsating current is smoothed by a smoothing capacitor 3, and then the resultant DC current is supplied to an inverter main circuit 4.

In the inverter main circuit 4, six witching devices U, V, W, X, Y, and Z are in three-phase bridge connection. Here, pairs of the switching devices U and X, V and Y, and W and Z are each connected in series; these series-connected circuits are all connected in parallel; and a DC voltage is applied across the parallel-connected circuit. In addition, respective connection points between the switching devices U and X, V and Y, and W and Z are connected to input terminals of a motor 5.

In First Embodiment, the switching devices U and X, V and Y, and W and Z included in the inverter main circuit 4 are each paired and fixed being tightened by means of a single fixing plate to a heat sink.

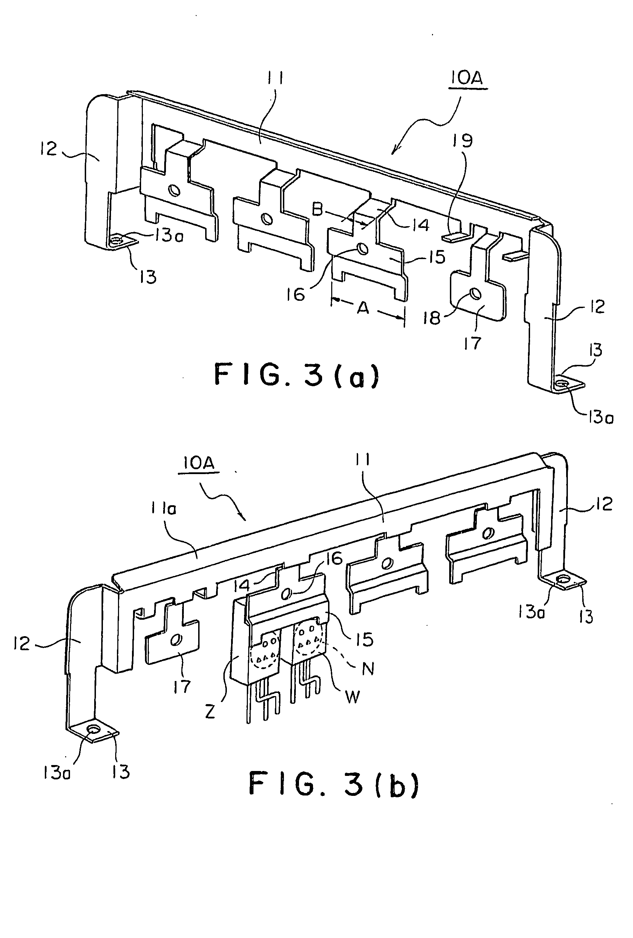

Fig. 2 is a perspective view illustrating a state in which the switching devices U, X, V, Y, W, and Z to be mounted on a printed board 6 are retained with a fixing plate and adhered to a heat sink, along with a mounted state of the rectifier 2.

In Fig. 2, through-holes into which respective terminals of the rectifier 2 and the switching devices U, X, V, Y, W, and Z are inserted are formed in the printed board 6 in such a way that the surfaces, to be cooled, of the rectifier 2 and the switching devices U, X, V, Y, W, and Z are situated on the same plane above the printed board 6. With the respective terminals of the rectifier 2 and the switching devices U, X, V, Y, W, and Z being inserted into these through-holes, the terminals are soldered. In order to adhere to a heat sink 7 the soldered rectifier 2 and the switching devices U, X, V, Y, W, and Z, a fixing plate 10A is mounted.

As illustrated in Fig. 3, the fixing plate 10A includes a base portion 11 that is formed being elongated in a direction in which the devices are arranged, a pair of leg portions 12 for supporting above the printed board 6 the base portion 11 at both longitudinal ends thereof, a foot portions 13 that abut on the device mounting surface, for the leg portions 12, on the printed board 6, three device-pressing portions 15 and a rectifier-pressing portion 17 that are provided being elongated and spaced apart from each other, at one side (the lower side) of the base portion 11 and that are coupled through coupling portions with the base portion; these portions are integrally formed with a metal plate, through bending and forming processing; and the foot portions 13 are fixed to the printed board 6, by upwardly advancing the screws 13b through the printed board 6 and the foot portions 13.

Here, being sandwiched between the rectifier-pressing portion 17 and the device-pressing portions 15, of the fixing plate 10A, and the heat sink 7, respectively, the rectifier 2 and the switching devices U, X, V, Y, W, and Z are fixed with the screws. As described later, the heat sink 7 has a mounting trunk portion to which the rectifier 2 and the switching devices U, X, V, Y, W, and Z are adhered and radiating fins situated on the backside of trunk portion. The device-pressing portions 15 and the rectifier-pressing portion 17 each have a through-hole for a screw; a screw is passed through the through-hole, and then screwed into a screw hole in the mounting trunk portion of the heat sink 7, thereby being fixed.

Figs. 3(a) and 3(b) are perspective views illustrating in detail the configuration of the fixing plate 10A; Fig. 3(a) illustrate the back side, of the fixing plate 10A, on which the rectifier 2 and the switching devices U, X, V, Y, W, and Z are fixed and which faces the heat sink 7; and Fig. 3(b) illustrates the front side, of the fixing plate 10A, that is opposite the side where the heat sink 7 is situated.

Here, in the fixing plate 10A, the base portion 11 having a bent portion 11a in the top portion thereof and the leg portions 12 that are elongated downwardly from both ends of the base portion 11 are integrally formed; further, the base portion 11 and the three device-pressing portions 15 and the rectifier-pressing portion 17 that are situated under the base portion 11 are integrally formed. Among these, the leg portion 12 has the foot portion 13 at the bottom end thereof; a through-hole 13a for a screw, for fixing to the printed board 6 the fixing plate 10A, is provided in the foot portion 13.

The device-pressing portions 15 is formed in a shape having a wide width, i.e., a width A, so that two switching devices, e.g., W and Z can concurrently be pressed with a predetermined spacing; the top end of the device-pressing portions 15 is coupled with the base portion 11, through a coupling portion 14 formed in such a way as to have a small width, i.e., a width B (<< A).

In this case, the coupling portion 14 is elongated obliquely downward from the base portion 11 and has such a shape that the top end thereof is bent approximately vertically downward; the device-pressing portion 15 is made to be in parallel with the base portion 11; and bending processing is applied to the device-pressing portion 15 in such a way that the device-pressing portion 15 has level differences in accordance with the surface contour of a device.

In addition, in the device-pressing portion 15, a through-hole 16 for a screw is provided at the middle of the longitudinal width thereof and in the vicinity of the coupling portion 14. The through-hole 16 for a screw is positioned in the space between a pair of the switching devices that is fixed by means of the device-pressing portion 15.

In this situation, the reason why the width B of the coupling portion 14 is made small is that, even though the thicknesses of a pair of the switching devices, e.g., W and Z are different due to manufacturing variation, a twist is caused so that tightening force by a screw is applied to both of the switching devices W and Z, and that, when the thicknesses of a pair of the switching devices W and Z are larger or smaller than those of the other switching devices U to Y, a bend is caused.

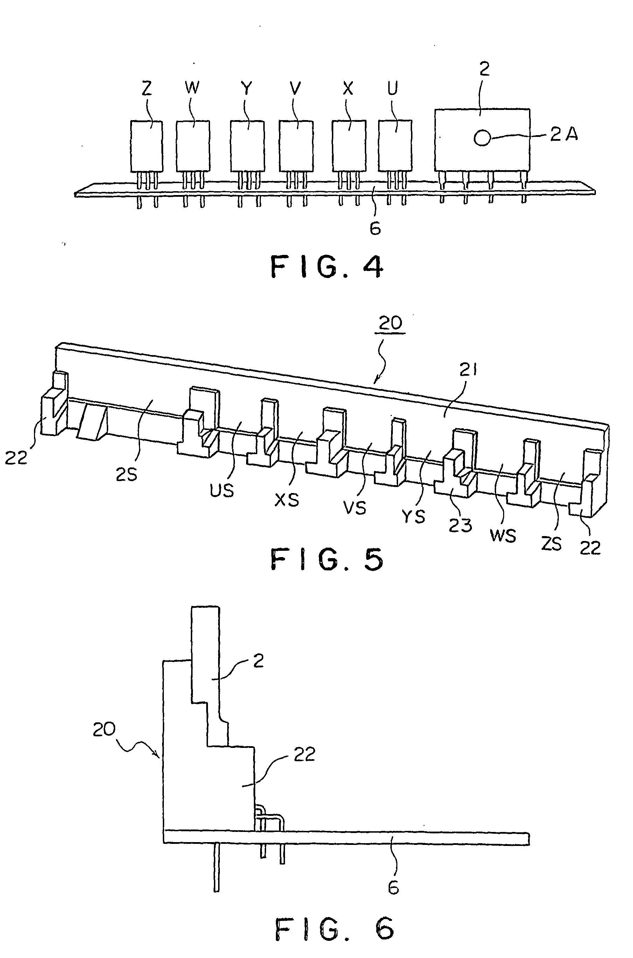

Moreover, the bottom end of the device-pressing portion 15 has an end-portion shape such that the switching devices U, X, V, Y, W, and Z are pressed without a type-name display portion "N" being covered, thereby enabling identification of the type names of the switching devices U, X, V, Y, W, and Z. The rectifier-pressing portion 17 for pressing the rectifier 2 is formed approximately as is the case with the device-pressing portion 15; as illustrated in Fig. 4, the rectifier 2 is fixed through the rectifier-pressing portion 17, by means of a screw that passes through a fixing hole 2A provided at the top center of the rectifier 2.

Here, the procedure for mounting on the printed board a heat radiation system according to First Embodiment will be explained.

In the first place, as illustrated in Fig. 4, each of terminals of the rectifier 2 and the switching devices U, X, V, Y, W, and Z is inserted into a predetermined through-hole formed in the printed board 6, in such a way that the cooling surfaces of the rectifier 2 and the switching devices U, X, V, Y, W, and Z face in the same direction, i.e., outward.

Fig. 5 is a perspective view schematically illustrating a configuration of a positioning jig 20 for, in soldering these terminals, aligning each of the cooling surfaces on the same plane. The positioning jig 20 has a plane portion 21 having in the lower portion thereof level differences in accordance with the contours of the devices; at both ends of the plane portion 21, positioning protrusions 22 are formed, and a plurality of positioning protrusions 23 are interposed between both of the positioning protrusions 22; and the spaces between these positioning protrusions make a rectifier-insertion portion 2S, and device-insertion portions US, XS, VS, YS, WS, and ZS.

As illustrated in Fig. 6, the rectifier 2 and the switching devices U, X, V, Y, W, and Z are inserted into the rectifier-insertion portion 2S of the positioning jig 20 and the device-insertion portions US, XS, VS, YS, WS, and ZS, respectively; the positioning jig 20 is held on the printed board 6; and, in this situation, each terminal is soldered to the printed board 6.

Next, by replacing the positioning jig 20 with the fixing plate 10A, illustrated in detail in Fig. 3, being placed in such a way that the front surfaces of the rectifier 2 and the switching devices U, X, V, Y, W, and Z and the rear surface of the fixing plate 10A face each other, by inserting screws into through-holes 13a for screws, in the foot portions 13, and by advancing the screws through the printed board 6, the fixing plate 10A is fixed to the printed board 6.

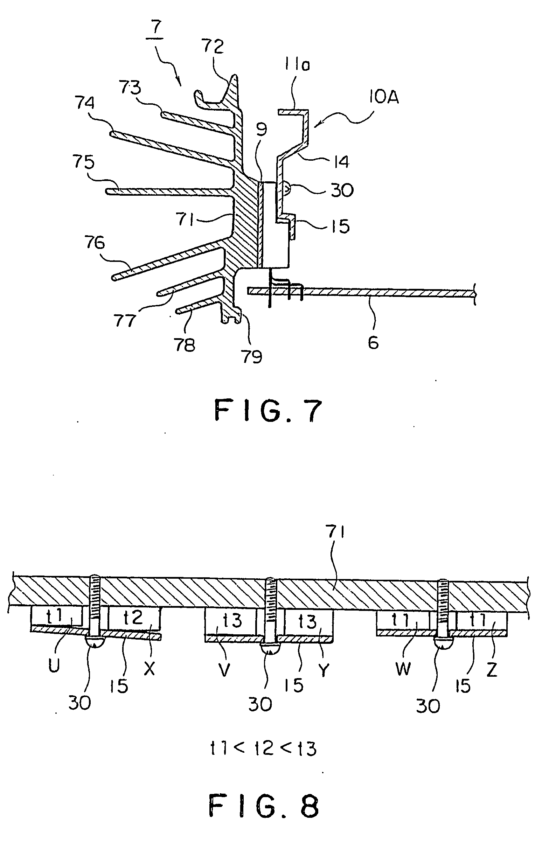

Subsequently, as illustrated in a cross-sectional view in Fig. 7, a mounting trunk portion 71 of the heat sink 7 having radiating fins 72 through 79 is pressed through an insulating sheet 9 against the rear surfaces of the rectifier 2 and the switching devices U, X, V, Y, W, and Z.

In this situation, by inserting a screw 30 into the through-hole 16 for a screw and advancing the screw 30 into a screw hole (unillustrated) in the heat sink 7, sets of two switching devices U and X, V and Y, and W and Z are sandwiched between the device-pressing portions 15 and the mounting trunk portion 71; by inserting a screw into a through-hole 18 for a screw and advancing the screw into a screw hole in the heat sink 7, the rectifier 2 is sandwiched between the rectifier-pressing portion 17 and the mounting trunk portion 71.

Accordingly, the cooling surfaces of the rectifier 2 and the switching devices U, X, V, Y, W, and Z are adhered to the rectifier-pressing portion 17 of the fixing plate 10A.

Fig. 8 illustrates a situation in which switching devices having different thicknesses are adhered to the mounting trunk portion 71 of the heat sink 7; for example, it is assumed that the thickness of the switching devices U, W, and Z is t1; X, t2 (> t1); V and Y, t3 (> t2).

In this situation, even when the thicknesses of the switching devices U and X to be fixed as a pair, by means of the device-pressing portion 15, are different from each other, when the device-pressing portion 15 is tightened with the screw 30, respective contact surfaces are adhered to the mounting trunk portion 71, thanks to a twist of the coupling portion 14 that couples the device-pressing portion 15 with the base portion 11.

In addition, the switching devices V and Y, and W and Z to be fixed as pairs, by means of the device-pressing portion 15, have a large thickness and a small thickness, respectively, in comparison to other pairs; however, because the thicknesses of the switching devices that configure a pair are equal to each other, respective contact surfaces are adhered to the mounting trunk portion 71, simply thanks to a bend of the coupling portion 14.

In general, switching devices are manufactured in such a way as to have packages of a uniform thickness; however, it is difficult to manufacture switching devices having completely the same size, and some tolerances exist. The tolerance is within one mm; however, if this small difference prevents a switching device from being sufficiently adhered to the heat sink 7, the device undergoes thermal destruction; therefore, the device and the heat sink 7 should securely be adhered to each other.

In addition, the insulating sheet 9 is interposed between a device and the heat sink 7; however, because of being a sheet having high heat-transfer efficiency and an extremely small and uniform thickness, the insulating sheet 9 does not adversely affect the adhesiveness between the device and the heat sink 7. Thus, in the foregoing discussion, the explanation for the sheet 9 has been omitted.

In consequence, according to First Embodiment of the present invention, the fixing plate 10A that is a single metal plate to which forming processing has been applied has the base portion 11 formed being elongated in the direction in which the switching devices U, X, V, Y, W, and Z are arranged and three device-pressing portions 15 that are formed at one side of the base portion 11, being coupled through the coupling portions 14 with the base portion 11, and being spaced apart form each other; the device-pressing portions 15 have a large width so that two switching devices as a pair are pressed; in contrast, the coupling portion 14 has a smaller width; therefore, even when there is variation in thickness between the switching devices, when the device-pressing portion 15 is tightened with a screw, the switching devices can be securely be adhered to a heat sink by a single fixing plate.

In addition, six switching devices utilized in a three-phase inverter should have the same ratings, e.g., a rated current of 15 A; however, in the case of a switching device having a small rated current, even though the rated current is different form others, the appearance and contour of the switching device are specified in the same way as the other switching devices are, whereby devices having different ratings may be intermingled in a manufacturing site.

In this regard, the device-pressing portion 15 has a shape such that the switching devices U, X, V, Y, W, and Z are pressed without type-name display portions "N" being covered, thereby enabling visual inspection of the type names and ratings of the switching devices, even though a plurality of kinds of switching devices made by different manufacturers are employed; thus, erroneous mounting can be prevented.

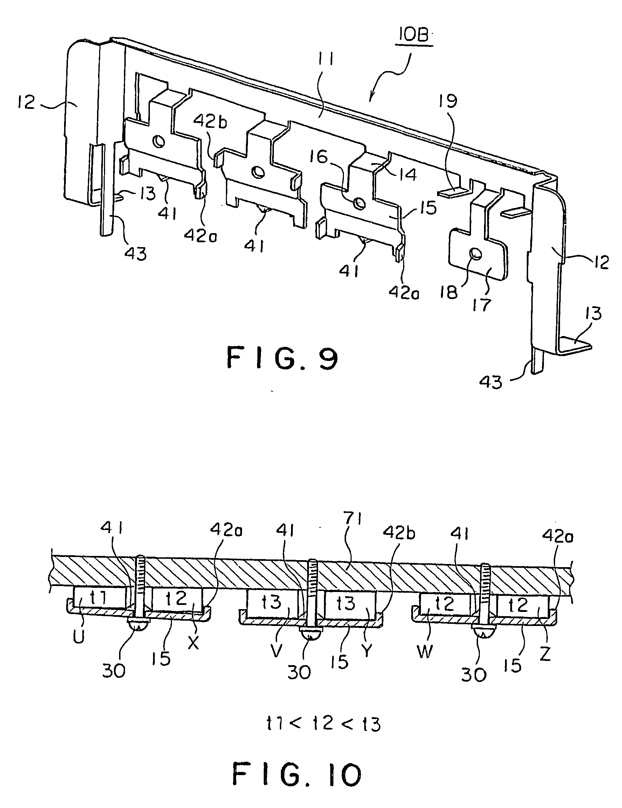

Fig. 9 is a perspective view, for explaining Second Embodiment of the present invention, illustrating a shape of a fixing plate 10B having a different configuration from that in First Embodiment. Second Embodiment is identical to First Embodiment, except for the fixing plate 10B; therefore, figures and explanations for the constituent elements will be omitted. In addition, the same constituent elements as those of the fixing plate 10A included in First Embodiment are indicated by the same reference marks, and explanations for them will be omitted.

The configuration of the fixing plate 10B illustrated in Fig. 9 is differentiated from that of the fixing plate 10A incorporated in First Embodiment by including a protrusion 41 that protrudes toward the device-mounting side, i.e., toward the heat sink, being bent at the middle of the longitudinal width of the device-pressing portion 15, arm portions 42a or 42b that protrude in an elongated form toward the heat sink, being bent at both ends of the longitudinal width of the device-pressing portion 15, and fixing protrusions 43 that are provided inside a pair of the leg portions 12 supporting the base portion 11 at both ends of the longitudinal width thereof and that are inserted into holes (unillustrated) formed in the printed board 6. Functions of what differ from the fixing plate 10A in terms of the configuration will be explained below.

When a pair of switching devices is fixed being tightened by means of the device-pressing portion 15, the devices may move against each other (left and right, respectively) due to the difference in thickness or the like. The protrusion 41 and the arm portions 42a or 42b appropriately position the switching devices; for example, as illustrated in Fig. 10, by making the planar shape of the protrusion 41 triangular, the protrusion 41 applies force to each of the switching devices, thereby each switching device being shifted outward in the direction of longitudinal width of the device-pressing portion 15, when the device-pressing portion 15 is pressed against the switching devices.

In this situation, the switching devices are pressed against the arm portions 42a or 42b that are bent toward the switching devices at both ends of the device-pressing portion 15. Accordingly, the positions of switching devices U, X, V, Y, W, and Z are defined; therefore, the devices can be appropriately spaced apart from each other.

In this case, if the arm portions 42a and 42b are formed at the same height, the device-pressing portions 15 should be more spaced apart from each other, because the fixing plate 10B itself is a single metal plate to which bending processing has been applied. In order to space the device-pressing portions 15 less apart from each other, with regard to the device-pressing portion 15 arranged in the middle, among the three device-pressing portions 15, the arm portions 42b are formed at the top sides thereof; with regard to the device-pressing portions 15 arranged at both sides, among the three device-pressing portions 15, the arm portions 42a are formed at the bottom sides thereof.

In addition, in Second Embodiment, the positions where the arm portions 42a or 42b provided at both sides of the device-pressing portion 15 are situated are at the same height from the printed board 6, for each device-pressing portion 15, and the positions where the arm portions 42a and 42b of neighboring device-pressing portions 15 are situated are at different heights; however, also by making the heights of the arm portions 42a provided at both sides of the device-pressing portion 15 different and making the heights of the arm portions facing each other, of the neighboring device-pressing portions 15 different, the same effect can be obtained.

Meanwhile, the fixing protrusion 43 formed in the vicinity of the leg portion 12 is inserted into a hole in the printed board 6 and soldered to the printed board 6, with the foot portion 13 abutting on the printed board 6; accordingly, an effect is demonstrated in which, before the leg portion 13 is fixed by a screw to the printed board 6, the fixing plate 10B can be positioned.

Fig. 10 is an explanatory view representing that, as explained with reference to Fig. 8, even though the thicknesses of the switching devices U, W, and Z are t1, the thickness of the switching device X is t2 (> t1), and the thicknesses of the switching devices V and Y are t3 (> t2), each contact surface is adhered to the mounting trunk portion 71, thanks to a twist or a bend of the coupling portion 14, and also illustrating the situation in which the positions of the switching devices U, X, V, Y, W, and Z are each defined by the protrusion 41 and the arm portions 42a or 42b.

As described heretofore, according to Second Embodiment, the fixing plate 10B of which is illustrated in Fig. 9, in addition to effects of First Embodiment, other effects can also be obtained in which the switching devices U, X, V, Y, W, and Z are appropriately spaced apart from each other; even though, for that purpose, the arm portions 42a or 42b are provided, because these arm portions are provided at different heights, the longitudinal length of the fixing plate 10B is saved, whereby the width of the printed board 6 does not have to be widened; and, prior to being fixed with a screw, the fixing plate 10B can be positioned, by providing the fixing protrusion 43.

As is clear from the foregoing explanation, according to the present invention, a heat radiation system can be provided in which, even though there is variation in thickness among six switching devices, all of these devices can securely be adhered to a heat sink, by means of a single fixing plate, i.e., by utilizing a small number of components.

## Claims

1. A heat radiation system comprising a fixing plate for fixing to a heat sink six switching devices arranged in a line on a printed board, wherein the fixing plate is made of a single metal plate to which forming processing has been applied, and has a base portion formed being elongated in a direction in which the switching devices are arranged and three device-pressing portions provided at one side of the base portion, in an elongated form being spaced apart form each other and being coupled through coupling portions with the base portion; wherein the device-pressing portion has a width, in the longitudinal direction of the base portion, for pressing two of the switching devices as a pair, and has a through-hole for a screw, formed in the middle of the longitudinal width thereof, for sandwiching the switching device between the device-pressing portion and the heat sink, and fastening the switching device to the heat sink; and wherein the coupling portion is formed so as to have a width smaller than that of the device-pressing portion so that, when the switching device is sandwiched and the device-pressing portion is fastened to the heat sink, the device-pressing portion can be moved obliquely against the heat sink.

2. The heat radiation system according to claim 1, wherein, if it is assumed that a surface, of the switching device, facing the heat sink is a rear surface, the type name of the switching device is displayed on the front surface thereof, and the device-pressing portion has a shape such that the switching device is pressed, without a type-name display portion being covered.

3. The heat radiation system according to claim 1 or claim 2, wherein the device-pressing portion includes a protrusion that protrudes toward the heat sink, being bent at the middle of the longitudinal width of the device-pressing portion, arm portions that protrude in an elongated form toward the heat sink, being bent at both ends of the longitudinal width of the device-pressing portion, and wherein the arm portions are provided at a height different from a height of the arm portions of the neighboring device-pressing portion, and the respective switching devices are fit between the protrusion and the arm portion.

4. The heat radiation system according to claim 1 to claim 3, wherein the fixing plate includes a pair of leg portions for supporting above the printed board the base portion at both longitudinal ends thereof, and the leg portion includes a foot portion that abuts on a device mounting surface of the printed board and a fixing protrusion that is inserted into a hole formed in the printed board.
